# EUROPEAN PATENT SPECIFICATION

(11) **EP 4 296 701 B1**
(45) Date of publication and mention of the grant of the patent: **06.08.2025**
(21) Application number: 22181104.5
(22) Date of filing: 24.06.2022
(51) Int. Cl.: G01R 31/392, G01R 31/389, G01R 31/387, G01R 31/385

(54) **BATTERY TEST SYSTEM, BATTERY TEST BENCH AND SERVER AND METHOD FOR ASSESSING A BATTERY STATE**
BATTERIETESTSYSTEM, BATTERIETESTSTAND UND SERVER SOWIE VERFAHREN ZUM BEURTEILEN EINES BATTERIEZUSTANDS
SYSTÈME DE TEST DE BATTERIE, BANC D'ESSAI DE BATTERIE ET SERVEUR ET PROCÉDÉ D'ÉVALUATION DE L'ÉTAT D'UNE BATTERIE

(43) Date of publication of application: 27.12.2023
(73) Proprietor: NOVUM engineerING GmbH, 01067 Dresden (DE)
(72) Inventor: Schipke, Mandy, 01307 Dresden (DE)
(74) Representative: Ter Meer Steinmeister & Partner

(56) References cited:
- CN-A- 114 280 479
- LYU CHAO ET AL: "SOH Estimation of Lithium-ion Batteries Based on Fast Time Domain Impedance Spectroscopy", 2019 14TH IEEE CONFERENCE ON INDUSTRIAL ELECTRONICS AND APPLICATIONS (ICIEA), IEEE, 19 June 2019 (2019-06-19), pages 2142 - 2147, XP033616357, DOI: 10.1109/ICIEA.2019.8834119

## Description

The invention relates to testing an electrochemical battery, in particular, performing a measurement on the electrochemical battery, and obtaining an output that represents battery state information relating to a current battery capacity. In the present disclosure, the term electrochemical battery includes a rechargeable electrochemical battery or accumulator.

WO 03/071617 A2 describes a method for determining a condition parameter of an electrochemical cell, such as in a battery. In an example, measurement signals such as terminal voltages, cell voltages, load current, charging current, ambient temperature, battery surface temperature, terminal temperature, internal battery temperature, and impedance signals are passed to a feature extraction processing algorithm, which generates a feature vector and a feature flag. Data from the feature vector is passed to a neural network ISOC predictor for initial battery capacity state of charge estimation, and a neural network CSOC predictor for continuous prediction of SOC during operation. In another example, the information contained in a feature vector is used by a neural network SOH classifier, a linear/statistical SOH classifier, and a fuzzy logic SOH classifier for state of health classification.

EP 3812783 A1 and US 2021/0123979 A1 describe a computer-implemented method of estimating a battery state of an electrochemical battery. The method includes determining a battery state of the electrochemical battery using artificial convolutional neural network means configured to receive as inputs a series of electrical impedance values. In examples, the battery state includes a state of health (SoH) of the electrochemical battery, or a capacity of the electrochemical battery.

LYU CHAO ET AL: "SOH Estimation of Lithium-ion Batteries Based on Fast Time Domain Impedance Spectroscopy", 2019 14th IEEE CONFERENCE ON INDUSTRIAL ELECTRONICS AND APPLICATIONS (ICIEA), IEEE, 19 June 2019, pages 2142-2147, XP033616357, DOI: 10.1109/ICIEA.2019.8834119, describes a method for estimating the state of health (SOH) of lithium-ion batteries. According to the document, in order to extract the characteristic information of SOH from the electrochemical impedance spectroscopy, it is necessary to transform the difference of EIS into the difference of model parameters with the help of an accurate lithium-ion battery model. The document proposes that on the basis of obtaining battery health characteristics in the form of model parameters, the SOH estimation of lithium-ion batteries can be realized by establishing a quantitative relationship between the health characteristics and the SOH of batteries. Taking the health characteristic parameters as input and the corresponding battery capacity as output, the relationship between them is solved by a BP neural network model algorithm, and the residual capacity of battery is estimated based on this.

CN 114 280 479 A describes a rapid sorting method for retired batteries based on electrochemical impedance spectroscopy (EIS), including: collecting EIS data of a battery cycle aging process and training a Bayesian neural network to obtain a remaining capacity estimation model; preliminary evaluation and EIS testing of retired power batteries to obtain EIS data of retired batteries; inputting the retired battery EIS data into the remaining capacity estimation model to obtain the estimated remaining capacity of the retired battery.

### Summary of the Invention

Generally, battery state estimation using an artificial neural network or other machine learning algorithm requires that the neural network or machine learning algorithm has been trained for a specific battery type. Conventionally, training of a neural network or machine learning algorithm is done using training data.

It is an object of the invention to provide a battery test system for assessing a battery state of electrochemical batteries, wherein the battery test system comprises a battery test bench that is easy to use.

It is desirable that the battery test bench allows for assessing a battery state of batteries of a same kind in a simple and time-saving manner.

It is desirable that the battery state of a battery can be assessed without requiring knowledge of the battery history and without reading a battery management system of the battery.

The invention is indicated in the independent claims. Further embodiments are indicated in the dependent claims.

According to one aspect of the invention, there is provided a battery test system for assessing a battery state of electrochemical batteries, wherein the battery test system comprises a battery test bench and a server,
wherein the battery test bench comprises:
a measurement device configured for performing a battery capacity measurement and an electrical impedance spectrum (EIS) measurement on an electrochemical battery connected to the measurement device, and
a communication interface configured for communicating with the server via a communication network,
wherein the server comprises:
   a machine learning algorithm for processing a measured electrical impedance spectrum,
   wherein the battery test system is configured for first performing first measurements on a number of batteries of a same kind (a first plurality of batteries of a same kind) to obtain first measurement data of each of the batteries, transmitting the first measurement data to the server via the communication network, and training the machine learning algorithm based on the first measurement data, and then performing a second measurement on at least one further battery of the same kind (or on a second plurality of batteries of the same kind) to obtain second measurement data, transmitting the second measurement data to the server via the communication network, and using the trained machine learning algorithm for evaluating the second measurement data,
   wherein performing the first measurements includes measuring a battery capacity of a respective battery and measuring an electrical impedance spectrum of the battery,
   wherein performing the second measurement includes measuring an electrical impedance spectrum of a respective battery,
   wherein using the trained machine learning algorithm for evaluating the second measurement data includes inputting the measured electrical impedance spectrum of a respective battery to the machine learning algorithm, processing the measured electrical impedance spectrum by the machine learning algorithm, and generating an output by the machine learning algorithm, wherein the output represents battery state information relating to a (current) battery capacity (that is, a battery capacity at the present time, or, more precisely, the time of the respective second measurement). According to the invention, the system is further configured to automatically switch from a training phase, in which the first measurements are performed for a number of batteries of a same kind, to an estimating phase, in which a second measurement is performed on a further battery of the same kind.

That is, the at least one further battery of the same kind (or on a second plurality of batteries of the same kind) is of the same kind as the number of batteries of a same kind (or first plurality of batteries of a same kind).

For example, the machine learning algorithm may be or may include at least one of: an artificial neural network, a support vector machine, a k-nearest neighbors algorithm, and a machine learning decision tree.

For example, the machine learning algorithm may be configured for processing a measured electrical impedance spectrum to generate an output. The machine learning algorithm is trained based on the first measurement data. For example, training the machine learning algorithm may be performed using the first measurement data as training data. The trained machine learning algorithm is used for evaluating the second measurement data. For example, the trained machine learning algorithm may be applied to the second measurement data. For example, the output of the machine learning algorithm may be called a prediction.

Preferably, training the machine learning algorithm based on the first measurement data includes providing the measured electrical impedance spectrum of a respective battery and the measured battery capacity of the battery to the machine learning algorithm as training data (as a training instance), wherein the measured battery capacity is input (and/or used) as a target value (or target output) for the measured electrical impedance spectrum (as an input vector).

Preferably, the training of the machine learning algorithm is performed automatically (by the server). However, training of the machine learning algorithm may also be performed by an operator of the server.

Assessing a battery state of electrochemical batteries is of high importance, for example, for reusing of used rechargeable batteries. Such battery 2nd life applications may include, for example, reusing used rechargeable batteries (traction batteries) of electric vehicles in (stationary) energy storage systems. In practice, for example, a user may have a large number of batteries of a same kind but with unknown and possibly different individual battery history or battery degradation. However, the battery test system is also useful for end-of-line tests for assessing a battery state of electrochemical batteries.

The battery test bench enables a user to simply connect batteries of a preselected same kind to the measuring device, for example, on after the other, and let the battery test bench perform the first measurements (in a first stage or a training stage / training phase, that is, for said number of batteries) and, afterwards, the second measurements (in a second stage or estimating stage / estimating phase, that is, for at least one further battery). That is, for a single electrochemical battery of said number of batteries of the same kind, a battery capacity of the battery and an electrical impedance spectrum of the battery are measured. And, after said number of batteries of the same kind have been measured (the first measurements have been performed for the respective batteries), for a single electrochemical battery of said at least one further battery of the same kind, an electrical impedance spectrum of the battery is measured (the second measurement is performed for the respective further battery). Thus, each battery may be assessed individually, based either on the first measurements or the second measurement.

Thus, an easy-to-use battery test bench is provided as a part of the system, and the system includes the machine learning algorithm that is automatically trained for batteries of a (specific) same kind based on the first measurements, which stem from the number of (first) batteries of the same kind. Thus, for further (second) batteries of the same kind (as the first batteries), the battery state may be quickly assessed by the machine learning algorithm based on the second measurements. Moreover, it is not necessary to test the individual batteries in a laboratory. Moreover, preferably, the further battery is connected to the measurement device through the same measurement connectors and/or in the same manner as each of said number of batteries of the same kind. That is, for the user, the battery handling and the handling of the battery test bench is the same for said number of batteries of the same kind and said at least one further battery of the same kind, apart from a difference in the duration of the measurement(s). In other words, training of the machine learning algorithm is performed automatically (or as-if automatically or quasi automatically) and with the batteries connected to the same measurement connectors as in the later usage of the machine learning algorithm. For example, training of the machine learning algorithm may be performed automatically.

Thus, the battery test system allows to quickly and reliably assess the battery status of a series of batteries of a same kind, thereby making it possible to select batteries according to obtained results (battery state information) for an intended use case, and to operate batteries more sustainably.

The battery test system combines artificial intelligence and electric impedance spectroscopy in a particularly advantageous manner: The system is able to train itself for a new battery type and afterwards quickly assess further batteries of the same kind. The second measurement on a battery may be performed much faster than the first measurements on a battery. Furthermore, knowledge of the battery history or reading the battery management system is not necessary. That is, the battery test system allows for assessing a battery state of electrochemical batteries independently of the battery history and, in particular, without reading a battery management system of the batteries. Thus, the battery state may be reliably assessed, even if the exact battery history is not available.

For example, the steps of performing the first measurement, transmitting the first measurement data to the server, and training the machine learning algorithm based on the first measurement data may be performed for one (a first one) of said number of batteries of a same kind, before these steps are repeated for a next one of said number of batteries of a same kind. These steps may be repeated for a respective next one of said number of batteries of a same kind until the steps have been performed for each of said number of batteries of a same kind.

Herein, the term "battery" is to be understood as including a battery cell. The battery may include one or more battery cells. In particular, the term "battery" includes a battery cell as well as a battery composed of multiple battery cells. Specifically, the electrochemical battery is understood as defining a device consisting of one or more electrochemical cells with external electrical connections. For example, the battery may include two external electrical connections for drawing power from the one or more electrochemical cells and, in case of a rechargeable electrochemical battery, for (re-)charging the one or more electrochemical cells. For example, the electrochemical battery may be a lithium-ion battery or a lead-acid battery.

In the present disclosure, the term battery test bench is used synonymously with the term battery test stand. The term "battery test bench" includes a battery test station, a battery test location, or a battery test rig.

In the present disclosure, the term "testing" a battery or to "test" a battery is used to include assessing a battery state of the battery.

The electrical impedance spectrum (EIS) measurement may also be called an electrical impedance spectroscopy measurement. Measuring an electrical impedance spectrum of the battery includes recording the electrical impedance spectrum. Using electrochemical impedance spectroscopy, electrochemical processes in an electrochemical battery are characterized by electrical measurements that characterize the AC response of the electrochemical battery to an applied AC signal. The chemical processes in the battery, in addition to the structural configuration and the configuration of the internal connectors, lead to characteristic frequency dependencies of the measured impedance. During the measurement of an electrical impedance at a specific measurement frequency, a DC offset signal (an offset voltage or an offset current) or DC bias signal may be applied to the battery, which is modulated by the AC signal of the measurement frequency.

The EIS measurement may include a number of electrical impedance measurements at different measurement frequencies. For example, the number of different measurement frequencies may be at least four, at least eight, at least 16, at least 32, or at least 64. For example, the respective measurement frequency may be a frequency of a signal input to the electrochemical battery. For example, the signal may be a sinusoidal signal. Preferably, each electrical impedance value of the measured electrical impedance spectrum comprises a complex number that defines a real part and an imaginary part of a respective electrical impedance. That is, the spectrum is a complex spectrum. Preferably, the measured electrical impedance spectrum is in a digitally represented form. The electrical impedance for the respective measurement frequencies may be measured in any order and/or concurrently.

Preferably, the measurement frequencies include a measurement frequency in the range of 0.1 to 1.0 Hz. Preferably, the measurement frequencies include a measurement frequency in the range of 1 kHz to 10 kHz. Preferably, the number of different measurement frequencies in the range of 0.1 Hz to 5000 Hz is at least four, at least eight, at least 16, at least 32, or at least 64. Preferably, the measurement frequencies include at least 4 (four) measurement frequencies per decade of the measurement frequency range, more preferably at least five measurement frequencies per decade of the measurement frequency range.

The battery test bench, in particular, the measurement device, is configured for performing the first and second measurements. The battery test bench, in particular, the communication interface, is configured for transmitting the first and second measurement data to the server. The server is configured for training the machine learning algorithm based on the first measurement data, and for using the trained machine learning algorithm for evaluating the second measurement data.

The batteries may be supplied and/or connected to the battery test bench one after the other. For example, the battery test bench may be configured for performing the above mentioned steps for testing a number of electrochemical batteries of a same kind (that is, the steps of performing first measurements, transmitting the first measurement data to the server, performing a second measurement, and transmitting the second measurement data to the server) when the electrochemical batteries of the same kind are connected to the measurement device one after another.

In the present disclosure, batteries of a same kind are to be understood as including batteries having the same nominal battery parameters or nominal characteristics (battery parameters/characteristics according to the manufacturer), in particular, a same nominal voltage, a same nominal electrical capacity (e.g. in mAh), and a same nominal energy capacity (e.g. in Wh), if applicable. However, the system may also be applied to batteries of a same kind that are selected based on a common and/or similar use case or location of use, when no battery parameter differences are known, or when the batteries are of a same kind according to their appearance. Battery parameters that may be taken into account may include at least one of a voltage rating, a capacity rating, an energy rating, a nominal voltage, a nominal battery capacity (for example, in mAh), a nominal energy capacity (for example, in Wh), a manufacturer's battery type information or code, battery cell chemistry information, a voltage per battery cell, a number of battery cells in the battery, etc.

For example, the battery test bench may be configured for receiving input that indicates a kind of battery (or battery kind) and/or input that indicates that a new series of batteries of a same kind is to be tested. In the present disclosure, the terms "batteries of a same kind" or "battery of the same kind" refer to the kind of battery. The kind of battery may include a type of battery (or battery type). For example, the battery test bench may comprise an input device for receiving input that indicates the kind of battery. For example, the input device may include or be a scanner or camera, such as a scanner or camera for scanning a battery code (such as a barcode) that indicates a kind of battery. For example, the input device may include a scanner or camera for recording an image of a battery. The battery test bench may be configured for identifying a kind of battery from a recorded image of the battery. This may be done, for example, by recognizing battery parameters, such as those mentioned above. Thus, the kind of a battery may be registered with the battery test system.

Preferably, the output of the machine learning algorithm represents one of battery capacity, state of health (SoH), and a classification.

In other words, the output of the machine learning algorithm may be one of an estimated battery capacity, an estimated state of health, and a classification. The classification will be explained further below.

In embodiments, the battery test system is configured for determining and outputting battery state information relating to a current battery capacity. Preferably, for said number of batteries of a same kind, the battery state information is determined based on the first measurement data of the respective battery, and/or for said at least one further battery of the same kind, the battery state information is determined based on the evaluating of the second measurement data by the machine learning algorithm.

Thus, during a training stage of the machine learning algorithm (for batteries of the same kind), that is, during the first stage, the system determines battery state information based on the first measurement data, and during the subsequent second stage, the system determines battery state information using the machine learning algorithm, which may be performed quickly. The first stage (of a series of assessing a battery state of batteries of a same kind) is performed for said number of batteries and includes performing the first measurements on each of the batteries as well as the steps of transmitting and training. The second stage (of the series of assessing a battery state of batteries of a same kind) is performed for said at least one further battery and includes performing the second measurements on each battery as well as the steps of transmitting and using the trained machine learning algorithm.

For example, for said at least one further battery of the same kind, the battery state information may be determined by the server or may be determined by the battery test bench, based on the evaluating of the second measurement data by the machine learning algorithm. For example, the server may be configured for transmitting the output of the machine learning algorithm to the battery test bench through the communication network. For example, the server may be configured for transmitting the battery state information that has been determined to the battery test bench through the communication network.

In the present disclosure, when the battery test bench or the server is configured for transmitting measurements, data, or information to the server or the battery test bench, respectively, the server or the battery test bench is configured for receiving said measurements, data, or information.

For example, the battery state information output by the system may be transmitted or communicated or output to an output device (such as a display, a printer, and/or a computer) for outputting the battery state information. The battery state information may be displayed and/or printed. For example, a label may be printed indicating the battery state information.

For example, for said number of batteries of a same kind, the battery state information may be determined based on the measured battery capacity; in particular, the battery state information that is determined and output by the system may be the measured battery capacity.

For example, for said at least one further battery of the same kind, the battery state information may be determined based on the processing of the measured electrical impedance spectrum by the machine learning algorithm.

For example, for said at least one further battery of the same kind, the output battery state information may be determined based on the output of the machine learning algorithm; in particular, the battery state information that is determined and output by the system may be the output of the machine learning algorithm.

In an embodiment, for said at least one further battery of the same kind, the output of the machine learning algorithm may represent first battery state information relating to a current battery capacity, and the battery state information that is determined and output by the system may be second battery state information relating to a current battery capacity, wherein the second battery state information is determined based on the first battery state information. For example, the output of the machine learning algorithm (the first battery state information) may be an estimation of current battery capacity, whereas the output of the system (the second battery state information) may be one of an estimated state of health, and a classification.

The output of the system may be at least one of an estimated battery capacity, an estimated state of health, and a classification. **In** an embodiment, the output of the system may be at least one of an estimated state of health, and a classification. For example, an estimated state of health (SoH) may be determined by dividing the estimated battery capacity (output by the machine learning algorithm) or, respectively, the measured battery capacity by a nominal battery capacity associated with the battery kind of the batteries. This may be expressed by the following equation: SoH = measured or estimated battery capacity / nominal battery capacity. The nominal battery capacity may be a battery capacity of the battery in its original condition (or manufacturing condition), according to the battery kind. For example, a classification may be determined according to an estimated state of health and/or according to an estimated battery capacity or, respectively, a measured battery capacity. This does not exclude that further parameters may be additionally used for determining the classification.

The classification that may be output by the machine learning algorithm and/or by the system is a classification of battery state. It may also be termed a battery grade or a battery rating. For example, the classification is selected from a number of classes, categories, grades or ratings. The number is, for example, less than 10, or less than 8, or is in the range of 3 to 6. For example, the number may be 4 or 5. For example, the classes may be "A", "B", "C", and "D". The number may depend on the kind of batteries to be assessed.

The measurement device may include a battery capacity measurement unit configured for performing a battery capacity measurement, and an electrical impedance measurement unit configured for performing an electrical impedance spectroscopy measurement. The units may be selectively operated and/or connected to the battery. In particular, a/the control unit of the battery test bench may be configured for selectively operating the measurement units and/or selectively connect the measurement units to the battery.

For example, the measurement device may include a source load for discharging a battery (a source) that is connected to the measurement device when performing the first measurements (for measuring the battery capacity). The term source load includes an energy sink and denotes an electrical load. For example, the source load may be configured for providing a power dissipation of at least 10 W permanent, preferably at least 15 W permanent.

For example, the measurement device may include a power supply for charging a battery that is connected to the measurement device when performing the first measurements (for measuring the battery capacity).

In preferred embodiments, performing the first measurements includes measuring the battery capacity of the respective battery by discharging.

Measuring a battery capacity by discharging is known as such and typically involves charging the battery (until a charge criterion is fulfilled, such as fully charging the battery) and then discharging the battery while maintaining predefined discharge parameters (such as constant load discharging or constant current discharging) until a discharge criterion is fulfilled. The battery capacity can then directly be calculated. For example, measuring the battery capacity may include bringing the battery into a defined state of charge. For example, measuring the battery capacity may include measuring a discharge current and/or discharge time of the battery.

For example, at least the major part (the larger part) of a duration of the first measurements on a battery may be used for discharging and/or charging the battery.

For example, depending on the current charging state of the battery and on the battery capacity, discharging and/or charging the battery may take a duration of up to between one and three hours.

For example, at least the major part (the larger part) of a duration of the second measurement on a battery may be used for measuring the electrical impedance spectrum.

**In** embodiments, a total duration of performing the second measurement on at least one further battery of the same kind to obtain second measurement data, transmitting the second measurement data to the server via the communication network, and using the trained machine learning algorithm for evaluating the second measurement data is less than 10 minutes, preferably less than 5 minutes, in particular less than 2 minutes.

**In** particular, a duration of a procedure, from connecting the further battery, to the machine learning algorithm generating the output or to the system outputting the battery state information, may be less than 10 minutes, preferably less than 5 minutes, in particular less than 2 minutes.

This is made possible by the second measurement not requiring a direct measurement of battery capacity or measurement of battery capacity by discharging.

Of performing the first measurements and performing the second measurement, only performing the first measurements includes measuring a battery capacity, for example by discharging.

**In** other words, when assessing the battery state of the at least one further battery, there is no battery capacity measurement performed in addition to the electrical impedance spectrum (EIS) measurement.

The first measurement data include the measured battery capacity of the respective battery and the measured electrical impedance spectrum of the battery. The second measurement data include the measured electrical impedance spectrum of the battery.

Thus, of the first measurement data and the second measurement data, only the first measurement data include a measured battery capacity of the respective battery.

Moreover, only for the first ones of the electrochemical batteries of a same kind, the battery state is determined based on a measurement of battery capacity (by discharging), whereas for the further ones of the electrochemical batteries of the same kind, the battery state may be received from the remote server or may be determined based on battery state information received from the remote server after electrical impedance spectrum measurement data have been sent to the remote server.

For example, the battery test bench may further comprise measurement connectors for connecting a battery (the state of which is to be assessed) to the measurement device. For example, the measurement connectors may be flexible measurement connectors, which may be integrated in a flexible connection cable. For example, the measurement connectors may be arranged to extend outside a housing of the measurement device.

For example, the battery test bench may comprise the measurement device and the measurement connectors for connecting a battery (that is to be tested) to the measurement device, wherein the measurement device is configured for performing a battery capacity measurement and an electrical impedance spectrum (EIS) measurement on an electrochemical battery connected to the measurement device through the measurement connectors.

For example, the measurement connectors may be configured for connecting battery poles of a battery (to be tested) to the measurement device. For example, the measurement connectors may be configured for enabling a 4-terminal-measurement (or Kelvin measurement) of the battery. This is particularly important for accurately measuring electrical impedance.

The server may be a remote server. The communication network may be a remote communication network. For example, the communication network may include the internet and/or a mobile communication network. Thus, the battery test bench and the server may be configured for remote communication.

In embodiments, the server is a remote server, and the communication network is a remote communication network.

Thereby, usage of the battery test bench is simplified. This allows a customer to save money on expensive specialist staff. Moreover, the requirements on the hardware capabilities and/or processing capabilities of the battery test bench may be lowered. For example, multiple battery test benches may share the remote server. Thereby, efficiency of the battery test system may be increased.

The machine learning algorithm is configured for processing a measured electrical impedance spectrum. That is, the machine learning algorithm is configured for receiving a measured electrical impedance spectrum of a battery as an input.

Information related to the battery kind (kind of battery) may additionally be transmitted to the server, for example, as a part of the first and second measurement data. Information related to the battery kind may additionally be input to the machine learning algorithm. Additionally or alternatively, in embodiments, the server may be configured to provide (implement) one or more further machine learning algorithms, wherein each machine learning algorithm (including the initially mentioned machine learning algorithm) is associated with a respective battery kind. In particular, training the respective machine learning algorithm may be performed based on first measurements on batteries of the associated kind of battery, and the respective machine learning algorithm may be used for evaluating a second measurement on a battery of the associated kind of battery. Thereby, battery states of series of batteries may be assessed, wherein each series is a series of batteries of a respective same kind, wherein the series have different battery kinds. For example, a first series has batteries of a first battery kind, and a second series has batteries of a second battery kind different from the first battery kind. In the following, only one machine learning algorithm is described for simplifying the description.

For example, the machine learning algorithm may be a neural network or may include a neural network. The neural network may be configured for processing a measured electrical impedance spectrum. For example, training the machine learning algorithm (or the neural network) based on the first measurement data may include inputting the measured electrical impedance spectrum of a respective battery to the neural network, processing the measured electrical impedance spectrum by the neural network, and/or adapting the neural network based on an output of the neural network and on the measured battery capacity of the battery. For example, using the trained machine learning algorithm (or the neural network) for evaluating the second measurement data may include inputting the measured electrical impedance spectrum of a respective battery to the neural network, processing the measured electrical impedance spectrum by the neural network, and generating an output by the neural network, wherein the output represents battery state information relating to a battery capacity.

For example, the neural network may include a deep neural network (DNN). A deep neural network has an input layer, more than one hidden layer, and an output layer. For example, the neural network may include a convolutional neural network (CNN). A convolutional neural network has an input layer, at least one convolutional layer, and an output layer. A CNN may be a deep neural network.

Preferably, the training is automatically performed. That is, the system is configured for automatically training the machine learning algorithm as described. Thus, the training of the machine learning algorithm (e.g. a neural network) based on the first measurements is a self-learning or self-training of the machine learning algorithm or neural network. **In** the present disclosure, the terms self-learning and self-training are used synonymously.

For example, adapting the neural network based on an output of the neural network and on the measured battery capacity of the battery may include providing a target value to the neural network, wherein the target value is determined based on the measured capacity of the battery; in particular, the target value may be the measured capacity of the battery. For example, the neural network may be adapted based on a comparison of and/or a difference between the output of the neural network and a target value that is based on the measured battery capacity.

Different from supervised learning, the target values for the respective inputs are automatically obtained, that is, for each input in the form of a measured electrical impedance spectrum, a target value is available based on / in the form of the measured battery capacitance, which is measured by the measurement device of the battery test system. Thus, the automatical training is not required to be supervised by a human operator or a user of the battery test bench.

And, different from unsupervised learning or self-supervised learning, the training is based on target values for the respective inputs, that is, for each input in the form of a measured electrical impedance spectrum, a target value is available based on / in the form of the measured battery capacitance.

Thus, the self-learning or self-training of the machine learning algorithm or neural network is not to be confused with unsupervised learning, in which no "correct" result (target value) is input in a learning step.

According to the invention, the battery test system is configured to automatically switch from a training phase, in which the first measurements are performed for each of a number of batteries of a (new) same kind, to an estimating phase, in which the second measurement is performed (for the same kind of batteries). For example, the system may switch from the training phase to the estimating phase when the first measurements have been performed on a predetermined number of batteries of the same kind and the machine learning algorithm has been trained based on the respective first measurements. The predetermined number may be selected based on experimental results. For example, the predetermined number may be in the range of 20 to 30. Or, for example, the system may switch from the training phase to the estimating phase in response to the server having determined that the training of the machine learning algorithm is completed for the batteries of the same kind. For example, the server may determine that the training of the machine learning algorithm is completed for the batteries of the same kind, based on a predetermined number of batteries of the same kind and/or based on an estimation error (or prediction error) of the machine learning algorithm (for example, based on a comparison of and/or a difference between the output of the machine learning algorithm and a target value that is based on the measured battery capacity) for one or more of the first measurements.

For example, the battery test bench may include a control unit for controlling the measurement device and the communication interface. In particular, the control unit may be configured for controlling the measurement device for performing the first and second measurements. The control unit may be configured for controlling the communication interface for communication between the battery test bench and the server, in particular, transmitting the first and second measurement data to the server and, if applicable, receiving the battery state information and/or the output of the machine learning algorithm from the server. For example, the control unit may be implemented in a computer of the battery test bench.

According to an aspect of the invention, there is provided a battery test bench, wherein the battery test bench comprises:
a measurement device configured for performing a battery capacity measurement and an electrical impedance spectrum measurement on an electrochemical battery connected to the measurement device, and
a communication interface configured for communicating with a server via a communication network, the server comprising a machine learning algorithm for processing a measured electrical impedance spectrum,
wherein the battery test bench is configured for first performing first measurements on a number of batteries of a same kind (a first plurality of batteries of a same kind) to obtain first measurement data of each of the batteries, transmitting the first measurement data to a server via the communication network (for training a machine learning algorithm of the server based on the first measurement data by the server), and then performing a second measurement on at least one further battery of the same kind (or on a second plurality of batteries of the same kind) to obtain second measurement data, transmitting the second measurement data to the server via the communication network (for evaluating the second measurement data by the machine learning algorithm of the server), and receiving from the server estimated battery state information relating to a (current) battery capacity,
wherein performing the first measurements includes measuring a battery capacity of a respective battery and measuring an electrical impedance spectrum of the battery,
wherein performing the second measurement includes measuring an electrical impedance spectrum of a respective battery, wherein the battery test bench is configured to switch from a training phase to an estimating phase in response to the server having determined that the training of the machine learning algorithm based on the first measurement data is completed for the batteries of the same kind, wherein in the training phase, the first measurements are performed for each of said number of batteries of a same kind, and wherein in the estimating phase, the second measurement is performed on said at least one further battery of the same kind.

The battery test bench may be a battery test bench for the battery test system, or may be the battery test bench of the battery test system.

According to an aspect of the invention, there is provided a server for assessing a battery state of electrochemical batteries, wherein the server comprises:
a machine learning algorithm for processing a measured electrical impedance spectrum, and
wherein the server is configured for first receiving first measurement data of each of a number of batteries of a same kind (a first plurality of batteries of a same kind) from a battery test bench via a communication network, training the machine learning algorithm based on the first measurement data, determining that the training of the machine learning algorithm based on the first measurement data is completed for the batteries of the same kind, and then receiving second measurement data of at least one further battery of the same kind (or on a second plurality of batteries of the same kind) from the battery test bench via a communication network, and using the trained machine learning algorithm for evaluating the second measurement data,
wherein the first measurement data include a measured battery capacity of the respective battery and a measured electrical impedance spectrum of the battery,
wherein the second measurement data include the measured electrical impedance spectrum of the battery,
wherein using the trained machine learning algorithm for evaluating the second measurement data includes inputting the measured electrical impedance spectrum of a respective battery to the machine learning algorithm, processing the measured electrical impedance spectrum by the machine learning algorithm, and generating an output by the machine learning algorithm, wherein the output represents battery state information relating to a (current) battery capacity.

Preferably, training the machine learning algorithm based on the first measurement data includes providing the measured electrical impedance spectrum of a respective battery and the measured battery capacity of the battery to the machine learning algorithm as training data (as a training instance), wherein the measured battery capacity is input (and/or used) as a target value (or target output) for the measured electrical impedance spectrum (as an input vector). For example, the machine learning algorithm may be a neural network or may include a neural network. For example, training the machine learning algorithm or the neural network based on the first measurement data may include inputting the measured electrical impedance spectrum of a respective battery to the neural network, processing the measured electrical impedance spectrum by the neural network, and/or adapting the neural network based on an output of the neural network and on the measured battery capacity of the battery (for example, used as a target output).

Preferably, the server is configured for automatically training the machine learning algorithm based on the first measurement data. That is, training of the machine learning algorithm is performed automatically.

The server may be a server for the battery test system, or may be the server of the battery test system. The server includes software configured for performing the mentioned steps performed by the server.

The server may include a communication interface configured for communicating with a battery test bench via a communication network.

According to an aspect of the invention, there is provided a method for assessing a battery state of electrochemical batteries, the method comprising:
for each of a number of batteries of a same kind (a first plurality of batteries of a same kind):
performing a first measurement on the battery to obtain first measurement data of the battery, wherein the first measurement is performed by a measurement device of a battery test bench, wherein the first measurement is performed while the respective electrochemical battery is connected to the measurement device,
transmitting the first measurement data from the battery test bench to the server via a communication network, and
training a machine learning algorithm of the server, based on the first measurement data; and,
for at least one further battery of the same kind (or for a second plurality of batteries of the same kind):
   performing a second measurement on the battery to obtain second measurement data, wherein the second measurement is performed by the measurement device of the battery test bench, wherein the second measurement is performed while the respective electrochemical battery is connected to the measurement device,
   transmitting the second measurement data from the battery test bench to the server via the communication network, and
   the server using the trained machine learning algorithm for evaluating the second measurement data,
   wherein performing the first measurement includes measuring a battery capacity of a respective battery and measuring an electrical impedance spectrum of the battery,
   wherein performing the second measurement includes measuring an electrical impedance spectrum of the respective battery,
   wherein using the trained machine learning algorithm for evaluating the second measurement data includes inputting the measured electrical impedance spectrum of the respective battery to the machine learning algorithm, processing the measured electrical impedance spectrum by the machine learning algorithm, and generating an output by the machine learning algorithm, wherein the output represents battery state information relating to a (current) battery capacity, wherein the method comprises: automatically switching from a training phase, in which the first measurements are performed for each of said number of batteries of a same kind, to an estimating phase, in which the second measurement is performed on said at least one further battery of the same kind.

Thus, the first and second measurements are respectively performed by the measurement device of the battery test bench, wherein each of the first and second measurements is performed while a respective electrochemical battery is connected to the measurement device. Preferably, training the machine learning algorithm based on the first measurement data includes providing the measured electrical impedance spectrum of a respective battery and the measured battery capacity of the battery to the machine learning algorithm as training data (as a training instance), wherein the measured battery capacity is input (and/or used) as a target value (or target output) for the measured electrical impedance spectrum (as an input vector). For example, the machine learning algorithm may be a neural network or may include a neural network. For example, training the machine learning algorithm or the neural network based on the first measurement data may include inputting the measured electrical impedance spectrum of the respective battery to the neural network, processing the measured electrical impedance spectrum by the neural network, and/or adapting the neural network based on an output of the neural network and on the measured battery capacity of the battery (for example, used as a target output).

Preferably, training the machine learning algorithm of the server is performed by the server. Preferably, training of the machine learning algorithm is performed automatically (by the server).

For example, the steps of performing the first measurement, transmitting the first measurement data to the server, and training the machine learning algorithm based on the first measurement data may be performed for one (a first one) of said number of batteries of a same kind, and these steps may be repeated for a respective next one of said number of batteries of a same kind (until the steps have been performed for each of said number of batteries of a same kind).

The battery test system may be configured for performing the method, or the method may be a method of operating the battery test system.

Preferred embodiments of the invention will now be described in conjunction with the drawings, in which:
- Fig. 1: is a schematic illustration of a battery test system for assessing a battery state of electrochemical batteries;
- Fig. 2: is a schematic illustration of assessing a battery state of an electrochemical battery and of a neural network self-learning operation as an example of a self-learning operation of a machine learning algorithm;
- Fig. 3: is a schematic illustration of assessing a battery state of an electrochemical battery using the trained neural network.

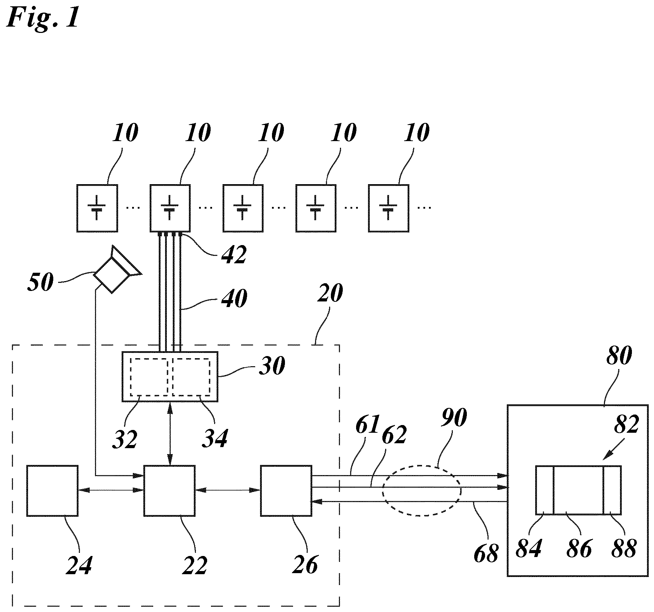

Fig. 1 schematically shows a battery test system for assessing a battery state of electrochemical batteries 10. The battery test system has a local component in the form of a battery test bench 20 and a remote component in the form of a server 80, which are configured to communicate through a remote communication network 90 such as the internet. In the embodiment, the server 80 includes a machine learning algorithm including a neural network 82. In the following, the handling of batteries 10 of only one battery kind is described, and only one machine learning algorithm or neural network 82 of the server 80 associated with that battery kind is described, for simplifying the description.

The battery test bench 20 includes a control unit 22, an output device 24, a communication interface 26 for communicating with the server 80, a measurement device 30, and a flexible cable of measurement connectors 40 having four terminals 42 for connecting a battery 10 to the measurement device 30 to enable a 4-terminal measurement on the poles of the battery 10. The control unit 22, the output device 24, and the communication interface 26 may be implemented in a computer, such as an industrial grade PC. For example, the output device 24 may be a display.

The battery test bench 20 further includes an input device 50 in the form of a scanner or camera for scanning a battery barcode that indicates a kind of battery.

The measurement device 30 includes a battery capacity measurement unit 32 configured for performing a battery capacity measurement by discharge, and an electrical impedance measurement unit 34 configured for performing an electrical impedance spectroscopy measurement. The control unit 22 controls both measurements, and both measurements can be performed while a battery 10 is connected through the measurement connectors 40.

The server 80 includes the artificial neural network 82 having an input layer 84, at least one hidden layer 86, and an output layer 88. The input layer 84 is configured to accept as input an electrical impedance spectrum measured by the electrical impedance measurement unit 34. The neural network 82 is configured to process the electrical impedance spectrum and generate therefrom an output at its output layer 88.

When using the battery test system, a user may supply and connect batteries 10 to be tested to the measurement device 30 one after another. In the following, assessing a battery state of a series of electrochemical batteries 10 of a same kind is described.

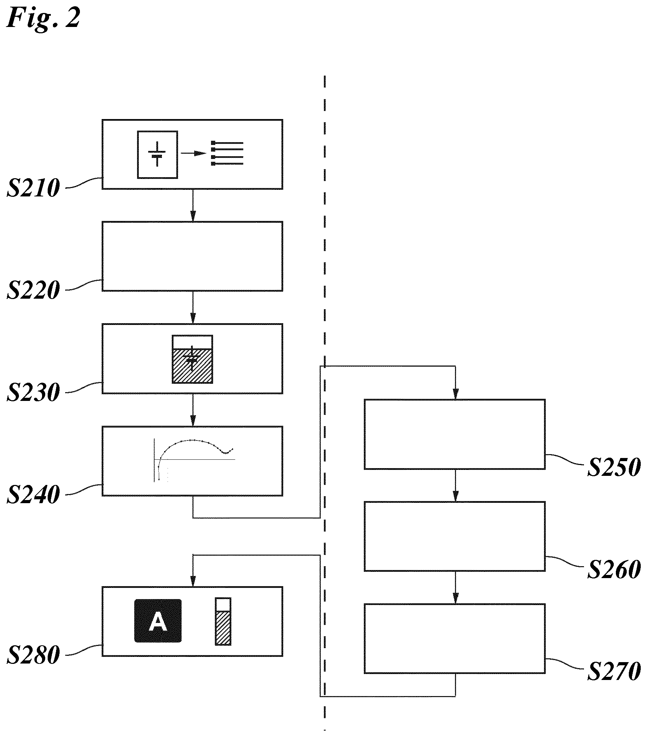

Fig. 2 schematically shows assessing a battery state of one of first batteries 10 of the series. Steps that are performed by the battery test bench 20 are shown on the left side, and steps that are performed by the server 80 are shown on the right side of a dashed vertical line.

In step S210, the battery 10 is connected to the measurement device 30 through the measurement connectors 40.

In step S220, the battery barcode is scanned using the input device 50, and the battery kind of the battery 10 is registered with the control unit 22 of the battery test bench 20.

The battery test bench 20 then begins the assessing of the battery state by performing first measurements. In step S230, the battery capacity of the battery 10 is measured by the battery capacity measurement unit 32. The duration thereof depends on the kind of battery and may take, for example, three hours.

In step S240, an electrical impedance spectrum of the battery 10 is measured by the electrical impedance measurement unit 34. However, the steps S230 and S240 may also be performed in reverse order.

First measurement data 61, which include the measured battery capacity and the measured electrical impedance spectrum, are transmitted to the server 80 (Fig. 1). The first measurement data 61 additionally include the battery kind.

In step S250, the server 80 inputs the measured electrical impedance spectrum to the neural network 82. In step S260, the neural network 82 processes the measured electrical impedance spectrum, resulting in an output of the neural network 82.

In step S270, the neural network 82 is adapted based on a difference between the obtained output of the neural network and the measured battery capacity.

Thereby, the neural network is self-trained based on the measured battery capacity as a target output.

In step S280, the battery test bench 20 determines battery state information based on the measured battery capacity and outputs the battery state information. In particular, the control unit 22 may divide the measured battery capacity by a nominal battery capacity that is associated with the registered battery kind to determine a state of health (SoH). For example, the battery state information may include the determined state of health as well as a grade of the battery that is determined by categorizing the battery 10 according to the determined state of health. The battery state information for the battery 10 is output by the output device 24.

By repeating the above describes procedure for a number of first batteries 10 of the series of batteries of a same kind, the neural network 82 is self-trained.

After completion of the self-training of the neural network 82, further second batteries 10 of the series of the same kind can be tested much faster, for assessing a battery state of the further batteries 10. For example, a number of 20 to 30 batteries may be used for training the neural network 82.

Thus, the neural network 82 of the machine learning algorithm has been self-trained, and the trained neural network 82 is configured to process a measured electrical impedance spectrum to generate an output that represents battery state information in the form of an estimation of a current battery capacity.

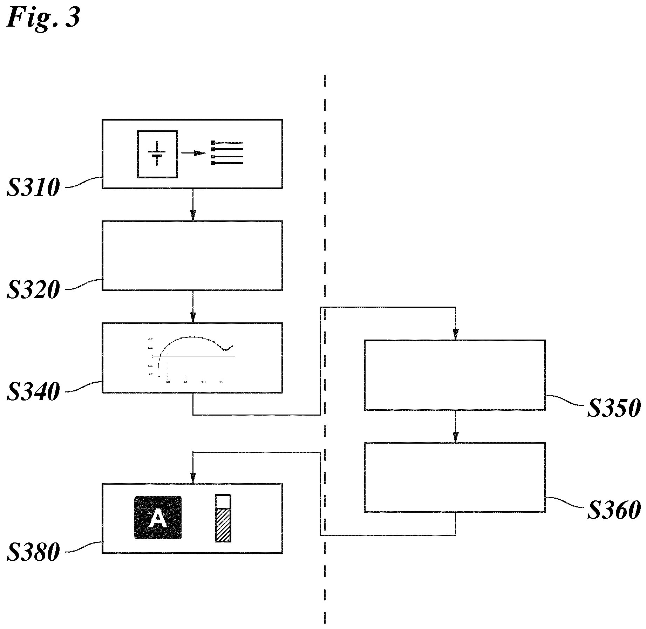

Fig. 3 schematically shows assessing a battery state of one of second batteries 10 of the series. Steps that are performed by the battery test bench 20 are shown on the left side, and steps that are performed by the server 80 are shown on the right side of a dashed vertical line.

In step S310, the battery 10 is connected to the measurement device 30 through the measurement connectors 40.

In step S320, the battery barcode is scanned using the input device 50, and the battery kind of the battery 10 is registered with the control unit 22 of the battery test bench 20.

The battery test bench 20 then begins the assessing of the battery state by performing second measurements. In step S340, an electrical impedance spectrum of the battery 10 is measured by the electrical impedance measurement unit 34.

Second measurement data 62 are transmitted to the server 80 (Fig. 1). The second measurement data 62 include the measured electrical impedance spectrum but do not include a measured battery capacity, as this is not part of the second measurements. The second measurement data 62 additionally include the battery kind.

In step S350, the server 80 inputs the measured electrical impedance spectrum to the trained neural network 82.

In step S360, the neural network 82 processes the measured electrical impedance spectrum, resulting in an output of the neural network 82. The output represents first battery state information 68 in the form of an estimated (current) battery capacity. The first battery state information 68 is transmitted to the battery test bench 20 (Fig. 1).

In step S380, the battery test bench 20 determines second battery state information based on the first battery state information 68 and outputs the second battery state information. In particular, the control unit 22 may divide the estimated battery capacity by a nominal battery capacity that is associated with the registered battery kind to determine a state of health (SoH). For example, the second battery state information may include the determined state of health as well as a grade of the battery that is determined by categorizing the battery 10 according to the determined state of health. The battery state information for the battery 10 is output by the output device 24.

## Claims

1. A battery test system for assessing a battery state of electrochemical batteries, wherein the battery test system comprises a battery test bench (20) and a server (80),
wherein the battery test bench (20) comprises:
a measurement device (30) configured for performing a battery capacity measurement and an electrical impedance spectrum measurement on an electrochemical battery (10) connected to the measurement device (30), and
a communication interface (26) configured for communicating with the server (80) via a communication network (90),
wherein the server (80) comprises:
a machine learning algorithm for processing a measured electrical impedance spectrum,
wherein the battery test system (20) is configured for first performing first measurements on a number of batteries (10) of a same kind to obtain first measurement data (61) of each of the batteries (10), transmitting the first measurement data (61) to the server (80) via the communication network (90), and training the machine learning algorithm based on the first measurement data (61), and then performing a second measurement on at least one further battery (10) of the same kind to obtain second measurement data (62), transmitting the second measurement data (62) to the server (80) via the communication network (90), and using the trained machine learning algorithm for evaluating the second measurement data (62),
wherein performing the first measurements includes measuring a battery capacity of a respective battery (10) and measuring an electrical impedance spectrum of the battery (10),
wherein performing the second measurement includes measuring an electrical impedance spectrum of a respective battery (10),
wherein using the trained machine learning algorithm for evaluating the second measurement data (62) includes inputting the measured electrical impedance spectrum of a respective battery (10) to the machine learning algorithm, processing the measured electrical impedance spectrum by the machine learning algorithm, and generating an output by the machine learning algorithm, wherein the output represents battery state information (68) relating to a battery capacity,
wherein the battery test system is configured to automatically switch from a training phase, in which the first measurements are performed for each of said number of batteries (10) of a same kind, to an estimating phase, in which the second measurement is performed on said at least one further battery (10) of the same kind.

2. The battery test system according to claim 1, wherein the output of the machine learning algorithm represents one of battery capacity, state of health, and a classification.

3. The battery test system according to claim 1 or 2, wherein the battery test system is configured for determining and outputting battery state information relating to a current battery capacity,
wherein for said number of batteries (10) of a same kind, the battery state information is determined based on the first measurement data (61) of the respective battery, and
wherein for said at least one further battery (10) of the same kind, the battery state information is determined based on the evaluating of the second measurement data (62) by the machine learning algorithm.

4. The battery test system according to any one of the preceding claims, wherein performing the first measurements includes measuring the battery capacity of the respective battery (10) by discharging.

5. The battery test system according to any one of the preceding claims, wherein at least the major part of a duration of the first measurements on a battery (10) is used for discharging and/or charging the battery (10).

6. The battery test system according to any one of the preceding claims, wherein at least the major part of a duration of the second measurement on a battery (10) is used for measuring the electrical impedance spectrum.

7. The battery test system according to any one of the preceding claims, wherein a total duration of performing the second measurement on at least one further battery (10) of the same kind to obtain second measurement data (62), transmitting the second measurement data (62) to the server (80) via the communication network (90), and using the trained machine learning algorithm for evaluating the second measurement data (62) is less than 10 minutes, preferably less than 5 minutes, in particular less than 2 minutes.

8. The battery test system according to any one of the preceding claims, wherein the battery test bench (20) further comprises measurement connectors (40) for connecting a battery (10) to the measurement device (30).

9. The battery test system according to any one of the preceding claims, wherein the server (80) is a remote server, and the communication network (90) is a remote communication network.

10. The battery test system according to any one of the preceding claims, wherein the machine learning algorithm includes an artificial neural network (82), wherein training the machine learning algorithm based on the first measurement data (61) includes inputting the measured electrical impedance spectrum of a respective battery (10) to the neural network (82), processing the measured electrical impedance spectrum by the neural network (82), and adapting the neural network (82) based on an output of the neural network (82) and on the measured battery capacity of the battery (10).

11. The battery test system according to any one of the preceding claims, wherein the server (80) is configured for automatically performing the training of the machine learning algorithm based on the first measurement data (61).

12. A battery test bench, wherein the battery test bench (20) comprises:
a measurement device (30) configured for performing a battery capacity measurement and an electrical impedance spectrum measurement on an electrochemical battery (10) connected to the measurement device (30), and
a communication interface (26) configured for communicating with a server (80) via a communication network (90), the server (80) comprising a machine learning algorithm for processing a measured electrical impedance spectrum,
wherein the battery test bench (20) is configured for first performing first measurements on a number of batteries (10) of a same kind to obtain first measurement data (61) of each of the batteries (10), transmitting the first measurement data to the server (80) via the communication network (90), and then performing a second measurement on at least one further battery (10) of the same kind to obtain second measurement data (62), transmitting the second measurement data (62) to the server (80) via the communication network (90), and receiving from the server (80) estimated battery state information (68) relating to a battery capacity,
wherein performing the first measurements includes measuring a battery capacity of a respective battery (10) and measuring an electrical impedance spectrum of the battery (10),
wherein performing the second measurement includes measuring an electrical impedance spectrum of a respective battery (10),
wherein the battery test bench is configured to switch from a training phase to an estimating phase in response to the server (80) having determined that the training of the machine learning algorithm based on the first measurement data (61) is completed for the batteries of the same kind, wherein in the training phase, the first measurements are performed for each of said number of batteries (10) of a same kind, and wherein in the estimating phase, the second measurement is performed on said at least one further battery (10) of the same kind.

13. A server for assessing a battery state of electrochemical batteries, wherein the server (80) comprises:
a machine learning algorithm for processing a measured electrical impedance spectrum, and
wherein the server (80) is configured for first receiving first measurement data (61) of each of a number of batteries (10) of a same kind from a battery test bench (20) via a communication network (90), training the machine learning algorithm based on the first measurement data (61), determining that the training of the machine learning algorithm based on the first measurement data (61) is completed for the batteries of the same kind, and then receiving second measurement data (62) of at least one further battery (10) of the same kind from the battery test bench (20) via the communication network (90), and using the trained machine learning algorithm for evaluating the second measurement data (62),
wherein the first measurement data (61) include a measured battery capacity of the respective battery (10) and a measured electrical impedance spectrum of the battery (10),
wherein the second measurement data (62) include the measured electrical impedance spectrum of the battery (10),
wherein using the trained machine learning algorithm for evaluating the second measurement data (62) includes inputting the measured electrical impedance spectrum of a respective battery (10) to the machine learning algorithm, processing the measured electrical impedance spectrum by the machine learning algorithm, and generating an output by the machine learning algorithm, wherein the output represents battery state information (68) relating to a battery capacity.

14. A method for assessing a battery state of electrochemical batteries, the method comprising:
for each of a number of batteries (10) of a same kind:
performing a first measurement on the battery (10) to obtain first measurement data (61) of the battery (10), wherein the first measurement is performed by a measurement device (30) of a battery test bench (20), wherein the first measurement is performed while the respective electrochemical battery (10) is connected to the measurement device (30),
transmitting the first measurement data (61) from the battery test bench (20) to the server (80) via a communication network (90), and
training a machine learning algorithm of the server (80), based on the first measurement data (61); and,
for at least one further battery (10) of the same kind:
performing a second measurement on the battery (10) to obtain second measurement data (62), wherein the second measurement is performed by the measurement device (30) of the battery test bench (20), wherein the second measurement is performed while the respective electrochemical battery (10) is connected to the measurement device (30),
transmitting the second measurement data (62) from the battery test bench (20) to the server (80) via the communication network (90), and
the server (80) using the trained machine learning algorithm for evaluating the second measurement data (62),
wherein performing the first measurement includes measuring a battery capacity of a respective battery (10) and measuring an electrical impedance spectrum of the battery (10),
wherein performing the second measurement includes measuring an electrical impedance spectrum of the respective battery (10),
wherein using the trained machine learning algorithm for evaluating the second measurement data (62) includes inputting the measured electrical impedance spectrum of the respective battery (10) to the machine learning algorithm, processing the measured electrical impedance spectrum by the machine learning algorithm, and generating an output by the machine learning algorithm, wherein the output represents battery state information (68) relating to a battery capacity,
wherein the method comprises: automatically switching from a training phase, in which the first measurements are performed for each of said number of batteries (10) of a same kind, to an estimating phase, in which the second measurement is performed on said at least one further battery (10) of the same kind.

## Patentansprüche

1. Ein Batterietestsystem zum Beurteilen eines Batteriezustands von elektrochemischen Batterien, wobei das Batterietestsystem einen Batterieteststand (20) und einen Server (80) aufweist,
wobei der Batterieteststand (20) aufweist:
eine Messvorrichtung (30), konfiguriert zum Durchführen einer Messung einer Batteriekapazität und einer Messung eines Spektrums der elektrischen Impedanz an einer mit der Messvorrichtung (30) verbundenen elektrochemischen Batterie (10), und
eine Kommunikationsschnittstelle (26), konfiguriert zum Kommunizieren mit dem Server (80) über ein Kommunikationsnetz (90),
wobei der Server (80) aufweist:
einen Algorithmus für maschinelles Lernen zum Verarbeiten eines gemessenen Spektrums der elektrischen Impedanz,
wobei das Batterietestsystem (20) dazu konfiguriert ist, zunächst erste Messungen an einer Anzahl von Batterien (10) einer gleichen Art durchzuführen, um erste Messdaten (61) von jeder der Batterien (10) zu erhalten, die ersten Messdaten (61) über das Kommunikationsnetz (90) an den Server (80) zu übertragen und den Algorithmus für maschinelles Lernen basierend auf den ersten Messdaten (61) zu trainieren, und dann eine zweite Messung an wenigstens einer weiteren Batterie (10) der gleichen Art durchzuführen, um zweite Messdaten (62) zu erhalten, die zweiten Messdaten (62) über das Kommunikationsnetz (90) an den Server (80) zu übertragen und den trainierten Algorithmus für maschinelles Lernen zum Auswerten der zweiten Messdaten (62) zu verwenden,
wobei das Durchführen der ersten Messungen ein Messen einer Batteriekapazität einer jeweiligen Batterie (10) und ein Messen eines Spektrums der elektrischen Impedanz der Batterie (10) umfasst,
wobei das Durchführen der zweiten Messung ein Messen eines Spektrums der elektrischen Impedanz einer jeweiligen Batterie (10) umfasst,
wobei das Verwenden des trainierten Algorithmus für maschinelles Lernen zum Auswerten der zweiten Messdaten (62) ein Eingeben des gemessenen Spektrums der elektrischen Impedanz einer jeweiligen Batterie (10) in den Algorithmus für maschinelles Lernen, ein Verarbeiten des gemessenen Spektrums der elektrischen Impedanz durch den Algorithmus für maschinelles Lernen und ein Erzeugen einer Ausgabe durch den Algorithmus für maschinelles Lernen umfasst, wobei die Ausgabe Batteriezustandsinformation (68), die sich auf eine Batteriekapazität bezieht, repräsentiert,
wobei das Batterietestsystem dazu konfiguriert ist, automatisch von einer Trainingsphase, in der die ersten Messungen für jede von der Anzahl von Batterien (10) einer gleichen Art durchgeführt werden, zu einer Schätzphase zu wechseln, in der die zweite Messung an der wenigstens einen weiteren Batterie (10) der gleichen Art durchgeführt wird.

2. Das Batterietestsystem nach Anspruch 1, wobei die Ausgabe des Algorithmus für maschinelles Lernen eine repräsentiert von einer Batteriekapazität, einem Gesundheitszustand und einer Klassifizierung.

3. Das Batterietestsystem nach Anspruch 1 oder 2, wobei das Batterietestsystem dazu konfiguriert ist, Batteriezustandsinformation, die sich auf eine aktuelle Batteriekapazität bezieht, zu bestimmen und auszugeben,
wobei für die Anzahl von Batterien (10) einer gleichen Art die Batteriezustandsinformation basierend auf den ersten Messdaten (61) der jeweiligen Batterie bestimmt wird, und
wobei für die wenigstens eine weitere Batterie (10) der gleichen Art die Batteriezustandsinformation basierend auf dem Auswerten der zweiten Messdaten (62) durch den Algorithmus für maschinelles Lernen bestimmt wird.

4. Das Batterietestsystem nach einem der vorhergehenden Ansprüche, wobei das Durchführen der ersten Messungen ein Messen der Batteriekapazität der jeweiligen Batterie (10) durch Entladen umfasst.

5. Das Batterietestsystem nach einem der vorhergehenden Ansprüche, wobei zumindest der größere Teil einer Dauer der ersten Messungen an einer Batterie (10) zum Entladen und/oder Laden der Batterie (10) verwendet wird.

6. Das Batterietestsystem nach einem der vorhergehenden Ansprüche, wobei zumindest der größere Teil einer Dauer der zweiten Messung an einer Batterie (10) zum Messen des Spektrums der elektrischen Impedanz verwendet wird.

7. Das Batterietestsystem nach einem der vorhergehenden Ansprüche, wobei eine Gesamtdauer des Durchführens der zweiten Messung an wenigstens einer weiteren Batterie (10) der gleichen Art zum Erhalten zweiter Messdaten (62), des Übertragens der zweiten Messdaten (62) über das Kommunikationsnetz (90) an den Server (80) und des Verwendens des trainierten Algorithmus für maschinelles Lernen zum Auswerten der zweiten Messdaten (62) weniger als 10 Minuten beträgt, vorzugsweise weniger als 5 Minuten, insbesondere weniger als 2 Minuten.

8. Das Batterietestsystem nach einem der vorhergehenden Ansprüche, wobei der Batterieteststand (20) weiter Messanschlüsse (40) zum Anschließen einer Batterie (10) an die Messvorrichtung (30) aufweist.

9. Das Batterietestsystem nach einem der vorhergehenden Ansprüche, wobei der Server (80) ein Fernserver ist und das Kommunikationsnetz (90) ein Fernkommunikationsnetz ist.

10. Das Batterietestsystem nach einem der vorhergehenden Ansprüche, wobei der Algorithmus für maschinelles Lernen ein künstliches neuronales Netz (82) umfasst, wobei das Trainieren des Algorithmus für maschinelles Lernen basierend auf den ersten Messdaten (61) ein Eingeben des gemessenen Spektrums der elektrischen Impedanz einer jeweiligen Batterie (10) in das neuronale Netz (82), ein Verarbeiten des gemessenen Spektrums der elektrischen Impedanz durch das neuronale Netz (82) und ein Anpassen des neuronalen Netzes (82) basierend auf einer Ausgabe des neuronalen Netzes (82) und auf der gemessenen Batteriekapazität der Batterie (10) umfasst.

11. Das Batterietestsystem nach einem der vorhergehenden Ansprüche, wobei der Server (80) dazu konfiguriert ist, das Trainieren des Algorithmus für maschinelles Lernen basierend auf den ersten Messdaten (61) automatisch durchzuführen.

12. Ein Batterieteststand, wobei der Batterieteststand (20) aufweist:
eine Messvorrichtung (30), konfiguriert zum Durchführen einer Messung einer Batteriekapazität und einer Messung eines Spektrums der elektrischen Impedanz an einer mit der Messvorrichtung (30) verbundenen elektrochemischen Batterie (10), und
eine Kommunikationsschnittstelle (26), konfiguriert zum Kommunizieren mit einem Server (80) über ein Kommunikationsnetz (90), wobei der Server (80) einen Algorithmus für maschinelles Lernen zum Verarbeiten eines gemessenen Spektrums der elektrischen Impedanz aufweist,
wobei der Batterieteststand (20) dazu konfiguriert ist, zunächst erste Messungen an einer Anzahl von Batterien (10) einer gleichen Art durchzuführen, um erste Messdaten (61) von jeder der Batterien (10) zu erhalten, die ersten Messdaten (61) über das Kommunikationsnetz (90) an den Server (80) zu übertragen, und dann eine zweite Messung an wenigstens einer weiteren Batterie (10) der gleichen Art durchzuführen, um zweite Messdaten (62) zu erhalten, die zweiten Messdaten (62) über das Kommunikationsnetz (90) an den Server (80) zu übertragen, und von dem Server (80) geschätzte Batteriezustandsinformation (68), die sich auf eine Batteriekapazität bezieht, zu empfangen,
wobei das Durchführen der ersten Messungen ein Messen einer Batteriekapazität einer jeweiligen Batterie (10) und ein Messen eines Spektrums der elektrischen Impedanz der Batterie (10) umfasst,
wobei das Durchführen der zweiten Messung ein Messen eines Spektrums der elektrischen Impedanz einer jeweiligen Batterie (10) umfasst,
wobei der Batterieteststand dazu konfiguriert ist, von einer Trainingsphase zu einer Schätzphase umzuschalten in Antwort darauf, dass der Server (80) bestimmt hat, dass das Trainieren des Algorithmus für maschinelles Lernen basierend auf den ersten Messdaten (61) für die Batterien der gleichen Art abgeschlossen ist, wobei in der Trainingsphase die ersten Messungen für jede von der Anzahl von Batterien (10) einer gleichen Art durchgeführt werden und wobei in der Schätzphase die zweite Messung an der wenigstens einen weiteren Batterie (10) der gleichen Art durchgeführt wird.

13. Ein Server zum Beurteilen eines Batteriezustands von elektrochemischen Batterien, wobei der Server (80) aufweist:
einen Algorithmus für maschinelles Lernen zum Verarbeiten eines gemessenen Spektrums der elektrischen Impedanz, und
wobei der Server (80) dazu konfiguriert ist, zunächst erste Messdaten (61) von jeder von einer Anzahl von Batterien (10) einer gleichen Art von einem Batterieteststand (20) über ein Kommunikationsnetz (90) zu empfangen, den Algorithmus für maschinelles Lernen basierend auf den ersten Messdaten (61) zu trainieren, zu bestimmen, dass das Trainieren des Algorithmus für maschinelles Lernen basierend auf den ersten Messdaten (61) für die Batterien der gleichen Art abgeschlossen ist, und dann zweite Messdaten (62) von mindestens einer weiteren Batterie (10) der gleichen Art von dem Batterieteststand (20) über das Kommunikationsnetz (90) zu empfangen und den trainierten Algorithmus für maschinelles Lernen zum Auswerten der zweiten Messdaten (62) zu verwenden,
wobei die ersten Messdaten (61) eine gemessene Batteriekapazität der jeweiligen Batterie (10) und ein gemessenes Spektrum der elektrischen Impedanz der Batterie (10) umfassen,
wobei die zweiten Messdaten (62) das gemessene Spektrum der elektrischen Impedanz der Batterie (10) umfassen,
wobei das Verwenden des trainierten Algorithmus für maschinelles Lernen zum Auswerten der zweiten Messdaten (62) ein Eingeben des gemessenen Spektrum der elektrischen Impedanz einer jeweiligen Batterie (10) in den Algorithmus für maschinelles Lernen, ein Verarbeiten des gemessenen Spektrums der elektrischen Impedanz durch den Algorithmus für maschinelles Lernen und ein Erzeugen einer Ausgabe durch den Algorithmus für maschinelles Lernen umfasst, wobei die Ausgabe Batteriezustandsinformation (68), die sich auf eine Batteriekapazität bezieht, repräsentiert.

14. Ein Verfahren zum Beurteilen eines Batteriezustands von elektrochemischen Batterien, wobei das Verfahren aufweist:
für jede von einer Anzahl von Batterien (10) einer gleichen Art:
Durchführen einer ersten Messung an der Batterie (10), um erste Messdaten (61) der Batterie (10) zu erhalten, wobei die erste Messung durch eine Messvorrichtung (30) eines Batterieteststands (20) durchgeführt wird, wobei die erste Messung durchgeführt wird, während die jeweilige elektrochemische Batterie (10) mit der Messvorrichtung (30) verbunden ist,
Übertragen der ersten Messdaten (61) vom Batterieteststand (20) über ein Kommunikationsnetz (90) an den Server (80), und
Trainieren eines Algorithmus für maschinelles Lernen des Servers (80), basierend auf den ersten Messdaten (61); und,
für wenigstens eine weitere Batterie (10) der gleichen Art:
Durchführen einer zweiten Messung an der Batterie (10), um zweite Messdaten (62) zu erhalten, wobei die zweite Messung durch die Messvorrichtung (30) des Batterieteststands (20) durchgeführt wird, wobei die zweite Messung durchgeführt wird, während die jeweilige elektrochemische Batterie (10) mit der Messvorrichtung (30) verbunden ist,
Übertragen der zweiten Messdaten (62) vom Batterieteststand (20) über das Kommunikationsnetz (90) an den Server (80), und
Verwenden des trainierten Algorithmus für maschinelles Lernen durch den Server (80) zum Auswerten der zweiten Messdaten (62),
wobei das Durchführen der ersten Messung ein Messen einer Batteriekapazität einer jeweiligen Batterie (10) und ein Messen eines Spektrums der elektrischen Impedanz der Batterie (10) umfasst,
wobei das Durchführen der zweiten Messung ein Messen eines Spektrums der elektrischen Impedanz der jeweiligen Batterie (10) umfasst,
wobei das Verwenden des trainierten Algorithmus für maschinelles Lernen zum Auswerten der zweiten Messdaten (62) ein Eingeben des gemessenen Spektrums der elektrischen Impedanz der jeweiligen Batterie (10) in den Algorithmus für maschinelles Lernen, ein Verarbeiten des gemessenen Spektrums der elektrischen Impedanz durch den Algorithmus für maschinelles Lernen und ein Erzeugen einer Ausgabe durch den Algorithmus für maschinelles Lernen umfasst, wobei die Ausgabe Batteriezustandsinformation (68), die sich auf eine Batteriekapazität bezieht, repräsentiert,
wobei das Verfahren aufweist: automatisches Umschalten von einer Trainingsphase, in der die ersten Messungen für jede von der Anzahl von Batterien (10) einer gleichen Art durchgeführt werden, zu einer Schätzphase, in der die zweite Messung an der wenigstens einen weiteren Batterie (10) der gleichen Art durchgeführt wird.

## Revendications

1. Système d'essai de batterie destiné à évaluer un état de batterie de batteries électrochimiques, dans lequel le système d'essai de batterie comporte un banc d'essai de batterie (20) et un serveur (80),
dans lequel le banc d'essai de batterie (20) comporte :
un dispositif de mesure (30) configuré pour réaliser une mesure de capacité de batterie et une mesure de spectre d'impédance électrique sur une batterie électrochimique (10) connectée au dispositif de mesure (30), et
une interface de communication (26) configurée pour communiquer avec le serveur (80) via un réseau de communication (90),
dans lequel le serveur (80) comporte :
un algorithme d'apprentissage automatique pour traiter un spectre d'impédance électrique mesuré,
dans lequel le système d'essai de batterie (20) est configuré pour réaliser d'abord des premières mesures sur un certain nombre de batteries (10) d'un même type afin d'obtenir des premières données de mesure (61) de chacune des batteries (10), transmettre les premières données de mesure (61) au serveur (80) via le réseau de communication (90), et entraîner l'algorithme d'apprentissage automatique sur la base des premières données de mesure (61), et réaliser ensuite une seconde mesure sur au moins une batterie supplémentaire (10) du même type afin d'obtenir des secondes données de mesure (62), transmettre les secondes données de mesure (62) au serveur (80) via le réseau de communication (90), et utiliser l'algorithme d'apprentissage automatique entraîné pour évaluer les secondes données de mesure (62),
dans lequel la réalisation des premières mesures inclut de mesurer une capacité de batterie d'une batterie (10) respective et de mesurer un spectre d'impédance électrique de la batterie (10),
dans lequel la réalisation de la seconde mesure inclut de mesurer un spectre d'impédance électrique d'une batterie (10) respective,
dans lequel l'utilisation de l'algorithme d'apprentissage automatique entraîné pour évaluer les secondes données de mesure (62) inclut d'entrer le spectre d'impédance électrique mesuré d'une batterie (10) respective dans l'algorithme d'apprentissage automatique, traiter le spectre d'impédance électrique mesuré par l'algorithme d'apprentissage automatique, et générer une sortie par l'algorithme d'apprentissage automatique, dans lequel la sortie représente une information d'état de batterie (68) se rapportant à une capacité de batterie,
dans lequel le système d'essai de batterie est configuré pour passer automatiquement d'une phase d'apprentissage, pendant laquelle les premières mesures sont réalisées pour chaque batterie dudit nombre de batteries (10) d'un même type, à une phase d'estimation, pendant laquelle la seconde mesure est réalisée sur ladite au moins une batterie supplémentaire (10) du même type.

2. Système d'essai de batterie selon la revendication 1, dans lequel la sortie de l'algorithme d'apprentissage automatique représente une information parmi une capacité de batterie, un état de santé et une classification.

3. Système d'essai de batterie selon la revendication 1 ou 2, dans lequel le système d'essai de batterie est configuré pour déterminer et sortir une information d'état de batterie se rapportant à une capacité de batterie actuelle,
dans lequel, pour ledit nombre de batteries (10) d'un même type, l'information d'état de batterie est déterminée sur la base des premières données de mesure (61) de la batterie respective, et
dans lequel, pour ladite au moins une batterie supplémentaire (10) du même type, l'information d'état de batterie est déterminée sur la base de l'évaluation des secondes données de mesure (62) par l'algorithme d'apprentissage automatique.

4. Système d'essai de batterie selon l'une quelconque des revendications précédentes, dans lequel la réalisation des premières mesures inclut de mesurer la capacité de batterie de la batterie (10) respective par décharge.

5. Système d'essai de batterie selon l'une quelconque des revendications précédentes, dans lequel au moins la majeure partie d'une durée des premières mesures sur une batterie (10) est utilisée pour décharger et/ou charger la batterie (10).

6. Système d'essai de batterie selon l'une quelconque des revendications précédentes, dans lequel au moins la majeure partie d'une durée de la seconde mesure sur une batterie (10) est utilisée pour mesurer le spectre d'impédance électrique.

7. Système d'essai de batterie selon l'une quelconque des revendications précédentes, dans lequel une durée totale de réalisation de la seconde mesure sur au moins une batterie supplémentaire (10) du même type afin d'obtenir des secondes données de mesure (62), de transmission des secondes données de mesure (62) au serveur (80) via le réseau de communication (90), et d'utilisation de l'algorithme d'apprentissage automatique pour évaluer les secondes données de mesure (62), est inférieure à 10 minutes, de préférence inférieure à 5 minutes, en particulier inférieure à 2 minutes.

8. Système d'essai de batterie selon l'une quelconque des revendications précédentes, dans lequel le banc d'essai de batterie (20) comporte en outre des connecteurs de mesure (40) pour connecter une batterie (10) au dispositif de mesure (30).

9. Système d'essai de batterie selon l'une quelconque des revendications précédentes, dans lequel le serveur (80) est un serveur distant, et le réseau de communication (90) est un réseau de communication distant.

10. Système d'essai de batterie selon l'une quelconque des revendications précédentes, dans lequel l'algorithme d'apprentissage automatique inclut un réseau neuronal artificiel (82), dans lequel l'apprentissage de l'algorithme d'apprentissage automatique sur la base des premières données de mesure (61) inclut d'entrer le spectre d'impédance électrique mesuré d'une batterie (10) respective dans le réseau neuronal (82), de traiter le spectre d'impédance électrique mesuré par le réseau neuronal (82), et d'adapter le réseau neuronal (82) sur la base d'une sortie du réseau neuronal (82) et de la capacité de batterie mesurée de la batterie (10).

11. Système d'essai de batterie selon l'une quelconque des revendications précédentes, dans lequel le serveur (80) est configuré pour effectuer automatiquement l'apprentissage de l'algorithme d'apprentissage automatique sur la base des premières données de mesure (61).

12. Banc d'essai de batterie, dans lequel le banc d'essai de batterie (20) comporte :
un dispositif de mesure (30) configuré pour réaliser une mesure de capacité de batterie et une mesure de spectre d'impédance électrique sur une batterie électrochimique (10) connectée au dispositif de mesure (30), et
une interface de communication (26) configurée pour communiquer avec un serveur (80) via un réseau de communication (90), le serveur (80) comportant un algorithme d'apprentissage automatique pour traiter un spectre d'impédance électrique mesuré,
dans lequel le banc d'essai de batterie (20) est configuré pour réaliser d'abord des premières mesures sur un certain nombre de batteries (10) d'un même type afin d'obtenir des premières données de mesure (61) de chacune des batteries (10), de transmettre les premières données de mesure au serveur (80) via le réseau de communication (90), et de réaliser ensuite une seconde mesure sur au moins une batterie supplémentaire (10) du même type afin d'obtenir des secondes données de mesure (62), de transmettre les secondes données de mesure (62) au serveur (80) via le réseau de communication (90), et de recevoir du serveur (80) une information d'état de batterie estimé (68) se rapportant à une capacité de batterie,
dans lequel la réalisation des premières mesures inclut de mesurer une capacité de batterie d'une batterie (10) respective et de mesurer un spectre d'impédance électrique de la batterie (10),
dans lequel la réalisation de la seconde mesure inclut de mesurer un spectre d'impédance électrique d'une batterie (10) respective,
dans lequel le banc d'essai de batterie est configuré pour passer d'une phase d'apprentissage à une phase d'estimation en réponse au fait que le serveur (80) a déterminé que l'apprentissage de l'algorithme d'apprentissage automatique sur la base des premières données de mesure (61) est terminé pour les batteries du même type, dans lequel, pendant la phase d'apprentissage, les premières mesures sont réalisées pour chaque batterie dudit nombre de batteries (10) d'un même type et dans lequel, pendant la phase d'estimation, la seconde mesure est réalisée sur ladite au moins une batterie supplémentaire (10) du même type.

13. Serveur destiné à évaluer un état de batterie de batteries électrochimiques, dans lequel le serveur (80) comporte :
un algorithme d'apprentissage automatique pour traiter un spectre d'impédance électrique mesuré, et
dans lequel le serveur (80) est configuré pour recevoir d'abord des premières données de mesure (61) de chaque batterie d'un certain nombre de batteries (10) d'un même type provenant d'un banc d'essai de batterie (20) via un réseau de communication (90), entraîner l'algorithme d'apprentissage automatique sur la base des premières données de mesure (61), déterminer que l'entraînement de l'algorithme d'apprentissage automatique sur la base des premières données de mesure (61) est terminé pour les batteries du même type, et recevoir ensuite des secondes données de mesure (62) d'au moins une batterie supplémentaire (10) du même type provenant du banc d'essai de batterie (20) via le réseau de communication (90), et utiliser l'algorithme d'apprentissage automatique entraîné pour évaluer les secondes données de mesure (62),
dans lequel les premières données de mesure (61) incluent une capacité de batterie mesurée de la batterie (10) respective et un spectre d'impédance électrique mesuré de la batterie (10),
dans lequel les secondes données de mesure (62) incluent le spectre d'impédance électrique mesuré de la batterie (10),
dans lequel l'utilisation de l'algorithme d'apprentissage automatique entraîné pour évaluer les secondes données de mesure (62) inclut d'entrer le spectre d'impédance électrique mesuré d'une batterie (10) respective dans l'algorithme d'apprentissage automatique, traiter le spectre d'impédance électrique mesuré par l'algorithme d'apprentissage automatique et générer une sortie par l'algorithme d'apprentissage automatique, dans lequel la sortie représente une information d'état de batterie (68) se rapportant à une capacité de batterie.

14. Procédé pour évaluer un état de batterie de batteries électrochimiques, le procédé comportant de :
pour chacune batterie d'un certain nombre de batteries (10) d'un même type :
réaliser une première mesure sur la batterie (10) afin d'obtenir des premières données de mesure (61) de la batterie (10), dans lequel la première mesure est réalisée par un dispositif de mesure (30) d'un banc d'essai de batterie (20), dans lequel la première mesure est réalisée alors que la batterie électrochimique (10) respective est connectée au dispositif de mesure (30),
transmettre les premières données de mesure (61) du banc d'essai de batterie (20) au serveur (80) via un réseau de communication (90), et
entraîner un algorithme d'apprentissage automatique du serveur (80), sur la base des premières données de mesure (61) ; et
pour au moins une batterie supplémentaire (10) du même type :
réaliser une seconde mesure sur la batterie (10) afin d'obtenir des secondes données de mesure (62), dans lequel la seconde mesure est réalisée par le dispositif de mesure (30) du banc d'essai de batterie (20), dans lequel la seconde mesure est réalisée alors que la batterie électrochimique (10) respective est connectée au dispositif de mesure (30),
transmettre les secondes données de mesure (62) du banc d'essai de batterie (20) au serveur (80) via le réseau de communication (90), et
le serveur (80) utilisant l'algorithme d'apprentissage automatique pour évaluer les secondes données de mesure (62),
dans lequel la réalisation de la première mesure inclut de mesurer une capacité de batterie d'une batterie (10) respective et de mesurer un spectre d'impédance électrique de la batterie (10),
dans lequel la réalisation de la seconde mesure inclut de mesurer un spectre d'impédance électrique de la batterie (10) respective,
dans lequel l'utilisation de l'algorithme d'apprentissage automatique entraîné pour évaluer les secondes données de mesure (62) inclut d'entrer le spectre d'impédance électrique mesuré de la batterie (10) respective dans l'algorithme d'apprentissage automatique, traiter le spectre d'impédance électrique mesuré par l'algorithme d'apprentissage automatique, et générer une sortie par l'algorithme d'apprentissage automatique, dans lequel la sortie représente une information d'état de batterie (68) se rapportant à une capacité de batterie,
dans lequel le procédé comporte de passer automatiquement d'une phase d'apprentissage, pendant laquelle les premières mesures sont réalisées pour chaque batterie dudit nombre de batteries (10) d'un même type, à une phase d'estimation, pendant laquelle la seconde mesure est réalisée sur ladite au moins une batterie supplémentaire (10) du même type.
